# EUROPÄISCHE PATENTSCHRIFT

(11) **EP 3 200 253 B1**
(45) Veröffentlichungstag und Bekanntmachung des Hinweises auf die Patenterteilung: **30.06.2021**
(21) Anmeldenummer: 16153391.4
(22) Anmeldetag: 29.01.2016
(51) Int. Cl.: H01L 51/05

(54) **VERFAHREN ZUM HERSTELLEN EINES VERTIKALEN ORGANISCHEN FELDEFFEKTTRANSISTORS UND VERTIKALER ORGANISCHER FELDEFFEKTTRANSISTOR**
METHOD FOR PRODUCING A VERTICAL ORGANIC FIELD EFFECT TRANSISTOR AND VERTICAL ORGANIC FIELD EFFECT TRANSISTOR
PROCÉDÉ DE FABRICATION D'UN TRANSISTOR À EFFET DE CHAMP ORGANIQUE VERTICAL ET TRANSISTOR À EFFET DE CHAMP ORGANIQUE VERTICAL

(43) Veröffentlichungstag der Anmeldung: 02.08.2017
(73) Patentinhaber: Novaled GmbH, 01099 Dresden (DE)
(72) Erfinder: Kleemann, Hans, 01099 Dresden (DE); Schwartz, Gregor, 01307 Dresden (DE)
(74) Vertreter: Bittner, Thomas L.

(56) Entgegenhaltungen:
- WO-A1-02/29912
- US-A1- 2006 148 167
- US-A1- 2007 090 362
- US-A1- 2009 286 361
- YUTANI K ET AL: "FABRICATION OF VERTICAL ORGANIC FIELD EFFECT TRANSISTOR AT THE EDGE OF PATTERNED PHOTORESIST", MOLECULAR CRYSTALS AND LIQUID CRYSTALS SCIENCE AND TECHNOLOGY. SECTION A. MOLECULAR CRYSTALS AND LIQUID CRYSTALS, GORDON AND BREACH PUBLISHERS, CH, CH, Bd. 444, 1. Januar 2006 (2006-01-01), Seiten 197-202, XP008067662, ISSN: 1058-725X, DOI: 10.1080/15421400500365128
- STUTZMANN N ET AL: "SELF-ALIGNED, VERTICAL-CHANNEL, POLYMER FIELD-EFFECT TRANSISTORS", SCIENCE, AMERICAN ASSOCIATION FOR THE ADVANCEMENT OF SCIENCE, Bd. 299, Nr. 5614, 21. März 2003 (2003-03-21), Seiten 1881-1884, XP001188271, ISSN: 0036-8075, DOI: 10.1126/SCIENCE.1081279

## Beschreibung

Die Erfindung betrifft ein Verfahren zum Herstellen eines vertikalen organischen Feldeffekttransistors und einen vertikalen organischen Feldeffekttransistor.

### Hintergrund

Ein vertikaler organischer Feldeffekttransistor weist drei Transistorelektroden auf, nämlich eine Drain-Elektrode, eine Source-Elektrode sowie eine Gate-Elektrode. Üblicherweise sind die Source-Elektrode und die Drain-Elektrode über einen organischen Halbleiter miteinander verbunden. Die Gate-Elektrode ist von der Source-Elektrode und der Drain-Elektrode mittels eines Isolierers elektrisch isoliert. Die Elemente des vertikalen organischen Feldeffekttransistors können als ein Stapel auf einem Substrat hergestellt werden.

Das Dokument WO 2010/113163 A1 offenbart einen vertikalen organischen Feldeffekttransistor und ein Verfahren zum Herstellen. Der Transistor weist eine Elektrodenstruktur mit einem Muster auf, welche zwischen einer dielektrischen Schicht und einem aktiven Material eingeschlossen ist.

Ein Verfahren zum Herstellen eines organischen Feldeffekttransistors ist weiterhin aus dem Dokument WO 2014/173738 A1 bekannt.

WO 02/29912 A1 offenbart einen vertikalen organischen Feldeffekttransistor und eine hydrophobe Oberfläche, um die Gate-Elektrode selektiv nur in einem ausgewählten Bereich abzuscheiden. Weitere Details zur hydrophoben Oberfläche wurden in N. Stutzmann et al, Science 2003, 299, 1881-1884 berichtet.

K. Yutani et al. Mol. Cryst. Liq. Cryst. 2006, 444, 197-2020 bezieht sich auf einen vertikalen organischen Feldeffekttransistor mit Transistorelektroden, nämlich eine erste Elektrode, eine zweite Elektrode und eine dritte Elektrode, elektrisch isolierenden Schichten und eine organische Halbleiterschicht.

US 2006/148167 A1 offenbart einen vertikalen organischen Feldeffekttransistor, wobei die Schichtanordnung auf einem Substrat basiert. Das Substrat umfasst einen Bereich mit einer haftenden Oberfläche für die Elektroden und einen weiteren Bereich mit nicht haftender Oberfläche für die Elektroden.

US 2007/090362 A1 und US2009286361 A1 offenbaren hydrophile/hydrophobe Schichten zur selektiven Abscheidung von Halbleiterschichten bei der Herstellung eines lateralen organischen Feldeffekttransistors.

### Zusammenfassung

Aufgabe der Erfindung ist es, ein Verfahren zum Herstellen eines vertikalen organischen Feldeffekttransistors sowie einen vertikalen organischen Feldeffekttransistor anzugeben, mit denen das

Strukturieren einer organischen Halbleiterschicht des vertikalen organischen Feldeffekttransistors vereinfacht ist.

Zur Lösung sind ein Verfahren zum Herstellen eines vertikalen organischen Feldeffekttransistors nach Anspruch 1 sowie ein vertikaler organischer Feldeffekttransistor nach dem unabhängigen Anspruch 9 geschaffen. Alternative Ausgestaltungen sind Gegenstand von abhängigen Unteransprüchen.

Nach einem Aspekt ist ein Verfahren zum Herstellen eines vertikalen organischen Feldeffekttransistors geschaffen. Bei dem Verfahren wird auf dem Substrat ein vertikaler organischer Feldeffekttransistor mit einer Schichtanordnung hergestellt, die Transistorelektroden, nämlich eine erste Elektrode, eine zweite Elektrode und eine dritte Elektrode, elektrisch isolierende Schichten sowie eine organische Halbleiterschicht aufweist. Im Rahmen des Verfahrens wird das Substrat bereitgestellt, um hierauf eine haftselektive Schicht abzuscheiden. Es wird eine Schichtteilstruktur des vertikalen organischen Feldeffekttransistors hergestellt, welche zumindest eine der Transistorelektroden und zumindest eine der elektrisch isolierenden Schichten aufweist, die in einem jeweiligen Berührungskontaktbereich auf der haftselektiven Schicht haften. Es wird die organische Halbleiterschicht hergestellt, indem wenigstens ein organisches Halbleitermaterial auf der Schichtteilstruktur haftend abgeschieden wird und außerhalb der Schichtteilstruktur die haftselektive Schicht ein haftendes Abscheiden des wenigstens einen organischen Halbleitermaterials verhindert. Schließlich wird eine verbleibende Schichtteilstruktur des vertikalen organischen Feldeffekttransistors hergestellt.

Nach einem weiteren Aspekt ist ein vertikaler organischer Feldeffekttransistor geschaffen, der auf einem Substrat eine Schichtanordnung mit Transistorelektroden, nämlich eine erste Elektrode, eine zweite Elektrode und eine dritte Elektrode, elektrisch isolierenden Schichten sowie eine organische Halbleiterschicht aus wenigstens einem organischen Halbleitermaterial aufweist, wobei die Schichtanordnung auf dem Substrat auf einer haftselektiven Schicht angeordnet ist, die für die Transistorelektroden sowie zumindest eine der elektrisch isolierenden Schichten einen Haftgrund und für die Halbleiterschicht einen Antihaftgrund bereitstellt.

Die Formulierung "haftselektiv" in Verbindung mit der Schicht gibt in der hier verwendeten Bedeutung an, dass die Schicht für das Material der zumindest einen Transistorelektrode sowie der zumindest einen elektrisch isolierenden Schicht einen Haftgrund bereitstellt, sodass diese Materialien beim Abscheiden auf der haftselektiven Schicht haften, wohingegen für das wenigstens eine organische Halbleitermaterial, welches zum Ausbilden der organischen Halbleiterschicht abgeschieden wird, einen Antihaftgrund bereitgestellt ist, sodass das organische Halbleitermaterial, wenn es beim Herstellen auf der Schicht abgeschieden wird, hierauf nicht haftet. Auf diese Weise bleiben Oberflächenbereiche außerhalb der zunächst hergestellten Schichtteilstruktur des vertikalen organischen Feldeffekttransistors frei von dem organischen Halbleitermaterial, welches zum Herstellen der organischen Halbleiterschicht abgeschieden wird. Hierdurch wird die organische Halbleiterschicht auf einfache Art und Weise strukturiert.

Die erste Elektrode kann als eine Drain-Elektrode oder eine Source-Elektrode ausgeführt sein. Entsprechend ist die zweite Elektrode als Source- oder Drain-Elektrode ausgebildet. Mit der dritten Elektrode ist eine Gate-Elektrode bereitgestellt.

Die Schichtteilstruktur kann mit der ersten Elektrode hergestellt werden.

Die organische Halbleiterschicht kann auf der ersten Elektrode, der zweiten Elektrode und der zumindest einen elektrisch isolierenden Schicht haftend abgeschieden werden.

Beim Herstellen der Schichtteilstruktur können die zumindest eine Transistorelektroden und die zumindest eine elektrisch isolierenden Schicht strukturiert werden.

Beim Strukturieren kann ein plasmaunterstütztes Ätzen ausgeführt werden. Hierbei kann eine Plasmaanwendung auch eine Oberfläche der Antihaftschicht außerhalb Schichtteilstruktur erfassen. Bei dieser Ausführungsform bleibt die Antihafteigenschaft der haftselektiven Schicht in Bezug auf das organische Halbleitermaterial auch nach der Plasmaanwendung erhalten.

Eine Schicht aus dem wenigstens einen organischen Halbleitermaterial, die beim Herstellen der Halbleiterschicht außerhalb der Schichtteilstruktur nicht haftend abgeschieden wird, kann mit einer Oberfläche der haftselektiven Schicht einen Kontaktwinkel von größer als 21 ± 2 Grad aufweisen.

Die Schicht aus dem wenigstens einen organischen Halbleitermaterial kann als nicht geschlossene Schicht gebildet sein. Die nicht geschlossene Schicht haftet nicht auf der selektiven Antihaftschicht.

Die haftselektive Schicht kann aus einem elektrisch isolierenden Material hergestellt sein. Beispielsweise kann das Material CYTOP (CYTOP 809 M, Asahi Glass Corp. Handelsname, Polyfluorofuran) zum Einsatz kommen.

Das Abscheiden des organischen Halbleitermaterials kann beispielsweise mittels "Spincoating" ausgeführt werden. Auch das Aufdrucken kann als Technologie für die Schichtherstellung verwendet werden.

Das Bestimmen des Kontaktwinkels kann mittels Messen an Tropfenvolumen zwischen etwa 2 bis 4µl der jeweiligen Halbleiterlösung durchgeführt werden. Der Kontaktwinkel kann mehrere verschiedene Tropfen, zum Beispiel drei bis fünf verschiedene Tropfen, auf mehr als zwei Positionen auf dem entsprechenden Substrat gemessen werden. Die Messwerte können jeweils aus den Einzelmessungen für eine spezielle Halbleiterlösung gemittelt werden (arithmetischer Mittelwert). Die Messungen können in Luft bei 22°C, 1010hPa und 35% relativer Luftfeuchtigkeit durchgeführt.

### Beschreibung von Ausführungsbeispielen

Im Folgenden werden weitere Ausführungsbeispiele unter Bezugnahme auf Figuren einer Zeichnung erläutert. Hierbei zeigen:
- Fig. 1: eine schematische Darstellung in Verbindung mit dem Strukturieren einer organischen Halbleiterschicht in einem vertikalen organischen Feldeffekttransistor nach dem Stand der Technik,
- Fig. 2: eine schematische Darstellung einer Schichtteilstruktur eines vertikalen organischen Feldeffekttransistors auf einem Substrat,
- Fig. 3: eine schematische Darstellung der Schichtteilstruktur aus Fig. 2, wobei hierauf eine organische Schicht abgeschieden ist,
- Fig.4: eine schematische Darstellung des vertikalen organischen Feldeffekttransistors, nachdem auf der Schichtteitstruktur aus Fig. 3 eine verbleibende Schichtteilstruktur hergestellt wurde,
- Fig. 5: eine graphische Darstellung für den Drain-Strom in Abhängigkeit von der Drain-Spannung für die Schichtteilstruktur aus Fig. 3,
- Fig. 6: eine graphische Darstellung für den Drain-Source-Strom in Abhängigkeit von der Gate-Source-Spannung für den vertikalen organischen Feldeffekttransistor aus Fig. 5, und
- Fig. 7: eine graphische Darstellung für den Drain-Source-Strom in Abhängigkeit von der Drain-Source-Spannung für den vertikalen organischen Feldeffekttransistor aus Fig. 5.

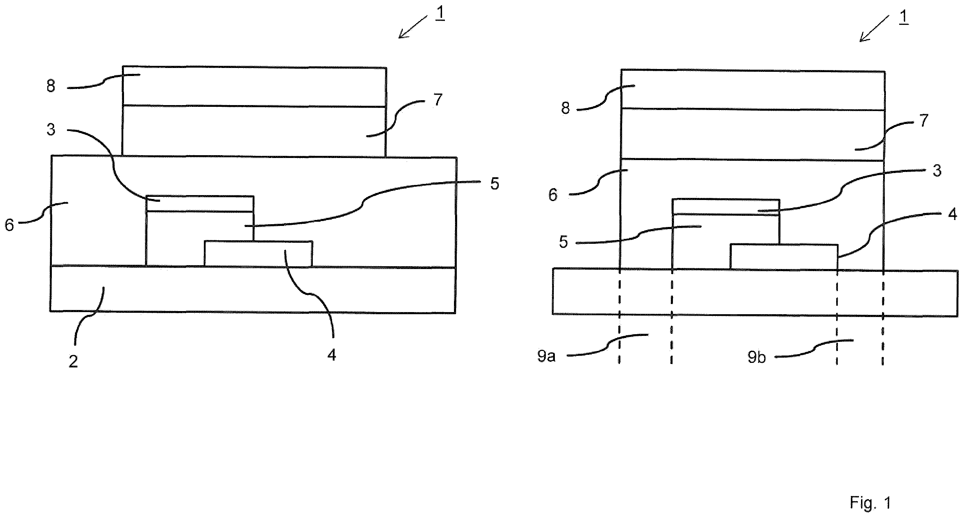

Fig. 1 zeigt eine schematische Darstellung zum Stand der Technik beim Strukturieren einer organischen Halbleiterschicht eines vertikalen organischen Feldeffekttransistors. Die linke Darstellung in Fig. 1 zeigt eine Schichtanordnung 1 des vertikalen organischen Feldeffekttransistors vor dem Strukturieren. Die rechte Darstellung in Fig. 1 zeigt den vertikalen organischen Feldeffekttransistor nach dem Strukturieren. Die Schichtanordnung 1 des organischen vertikalen Feldeffekttransistors ist auf einem Substrat 2 hergestellt und umfasst eine Drain-Elektrode 3 sowie eine Source-Elektrode 4, die mittels einer elektrisch isolierenden Schicht 5 voneinander elektrisch isoliert sind. In einer alternativen Ausführung (nicht dargestellt) sind Drain- und Source-Elektrode 2, 3, die allgemein eine erste und eine zweite Elektrode bilden, vertauscht. Gemäß der linken Darstellung in Fig. 1 ist eine organische Halbleiterschicht 6 hergestellt, worauf dann eine weitere elektrisch isolierende Schicht 7 sowie eine Gate-Elektrode 8 abgeschieden sind. Die organische Halbleiterschicht 6 wird mittels Plasmaätzen strukturiert. Der sich ergebende vertikale organische Feldeffekttransistor ist in der rechten Darstellung in Fig. 1 gezeigt. Es verbleiben sogenannte Todbereiche 9a, 9b, die zu unerwünschten Leckströmen führen können.

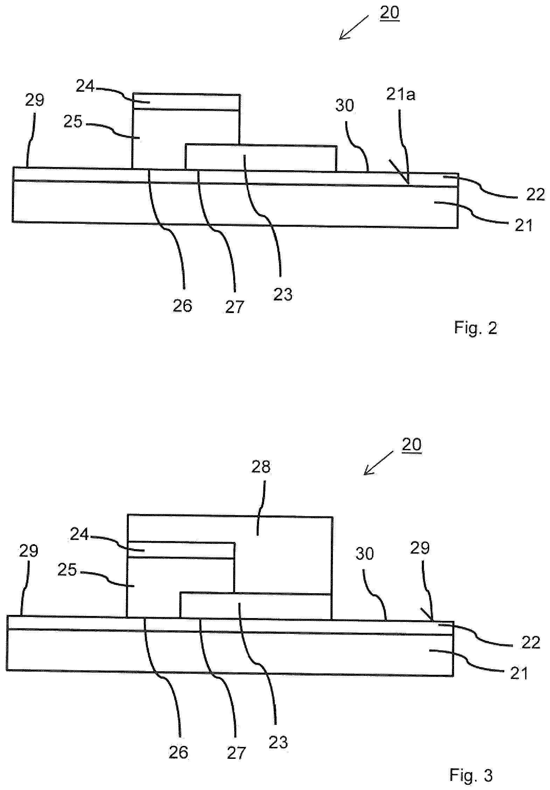

Fig. 2 zeigt eine schematische Darstellung einer Schichtteilstruktur 20 für einen vertikalen organischen Feldeffekttransistor auf einem Substrat 21. Auf dem Substrat 21 ist eine haftselektive Schicht 22 abgeschieden, die wahlweise als eine Planierungsschicht ausgebildet ist, mit der eine Oberfläche 21a des Substrats 21 geglättet ist. Die Schichtteilstruktur 20 des vertikalen organischen Feldeffekttransistors umfasst eine erste Elektrode 23, die als Drain- oder Source-Elektrode ausgebildet sein kann, eine zweite Elektrode 24, die als Source- oder Drain-Elektrode ausgebildet ist, sowie eine elektrisch isolierende Schicht 25, die zwischen der ersten Elektrode 23 und der zweiten Elektrode 24 angeordnet ist und die beiden Elektroden elektrisch isoliert. Sowohl die erste Elektrode 23 wie auch die elektrisch isolierende Schicht 25 haften in zugeordneten Berührungskontaktbereichen 26, 27 auf der haftselektiven Schicht 22.

Gemäß Fig. 3 wird auf der Schichtteilstruktur 20 des vertikalen organischen Feldeffekttransistors eine organische Halbleiterschicht 28 aus einem oder mehreren organischen Halbleitermaterialien abgeschieden. Da die haftselektive Schicht 22 für das oder die organischen Halbleitermaterialien einen Antihaftgrund bildet, kommt zu keinem haftenden Abscheiden der organischen Halbleiterschicht 28 in Bereichen 29, 30 außerhalb der Schichtteilstruktur 20. Sogenannten Todbereiche sind vermieden.

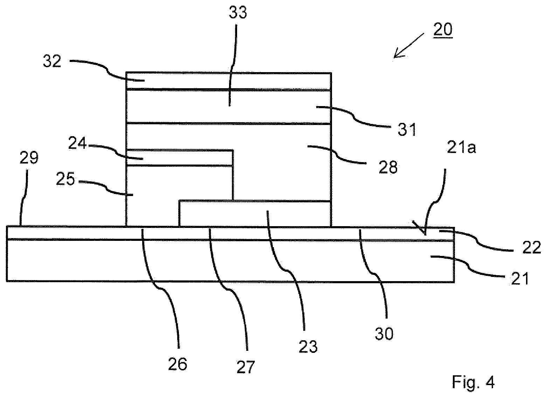

Fig. 4 zeigt eine schematische Darstellung für den vertikalen organischen Feldeffekttransistor ausgehend von der Anordnung in Fig. 3, wobei nun eine verbleibende Schichtteilstruktur 31 mit einer Gate-Elektrode 32 und einer weiteren elektrisch isolierenden Schicht 33 auf der organischen Halbleiterschicht 28 abgeschieden sind.

In einem Ausführungsbeispiel kann die haftselektive Schicht 22 auf dem Substrat 21 als Schicht aus CYTOP abgeschieden werden. Die erste Elektrode 23 kann mittels Aufdampfen von Gold hergestellt werden, wobei eine Schichtdicke von etwa 20nm vorgesehen sein kann. Die erste Elektrode 23 kann hierbei lithografisch strukturiert werden. Die elektrisch isolierende Schicht 25 kann aus einem nicht-haftselektiven Material hergestellt werden, zum Beispiel PMMA oder SiO2. Alternativ kann die elektrisch isolierende Schicht 25 in einer Ausgestaltung aus CYTOP hergestellt werden, wobei eine Schichtdicke von etwa 400nm vorgesehen sein kann. In diesem Fall wird eine haftselektive Wirkung des Materials CYTOP mittels Strukturieren unter Verwendung eines Sauerstoff-Plasmas aufgehoben. Die haftselektive Wirkung beliebt lediglich in den Bereichen 29 und 30 bleibt erhalten (vgl. http://dx.doi.org/10.1063/1.3058601)

Die zweite Elektrode 24 kann aus Gold prozessiert werden, wobei eine Schichtdicke von etwa 40nm vorgesehen sein kann. Die Strukturierung kann mittels Plasma unterstütztem Ätzen ausgeführt werden. Dieses bedeutet, dass hierbei auch die haftselektive Schicht 22 der Plasmaanwendung ausgesetzt ist, zum Beispiel kann ein Sauerstoff-Plasma angewendet werden.

Auf der so hergestellten Schichtteilstruktur nach Fig. 4 wird dann die organische Halbleiterschicht 25 abgeschieden, wobei es wegen der Antihaftwirkung der haftselektiven Schicht 22 für das organische Material zu keiner haftenden Abscheidung des organischen Materials außerhalb der Schichtteilstruktur 20 kommt (vgl. Fig. 3).

Schließlich werden (vgl. Fig. 4) die weitere elektrisch isolierende Schicht 26 sowie die Gate-Elektrode 32 abgeschieden, um den vertikalen organischen Feldeffekttransistor herzustellen.

Fig. 5 zeigt eine grafische Darstellung des Drain-Stroms in Abhängigkeit von der Drain-Spannung für die in Fig. 3 gezeigte Anordnung. Bei Annahme einer Raumladungsbegrenzung (Strom (I) proportional zum Quadrat der Spannung (V)) ergibt sich eine Beweglichkeit der Löcher im Halbleitermaterial von 3x10⁻² cm2 / Vs.

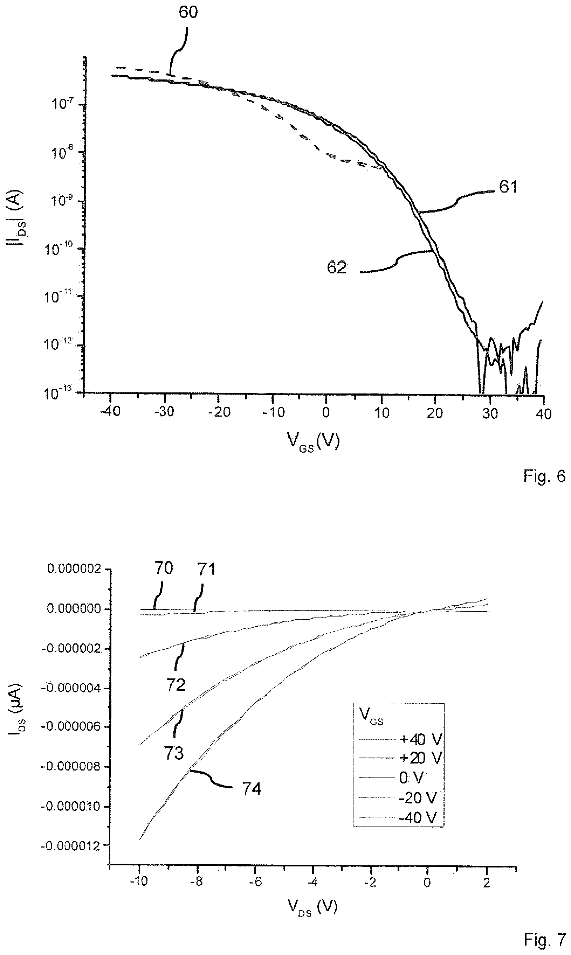

Die Fig. 6 und 7 zeigen grafische Darstellungen für den vertikalen organischen Feldeffekttransistor aus Fig. 4 für einen Transistor mit einer haftselektiven Schicht 29 (durchgängige Kurve in Fig. 6) und einen Transistor mit einer nicht-haftselektiven Schicht 29 (gestrichelte Linie). Fig. 6 zeigt den Drain-Source-Strom in Abhängigkeit von der Gate-Source-Spannung. Eine Kurve 60 zeigt den Verlauf für einen vertikalen organischen Feldeffekttransistor nach dem Stand der Technik gemäß Fig. 1. Kurven 61 und 62 zeigen Verläufe für den vertikalen organischen Feldeffekttransistor gemäß Fig. 4. Die Kanalbreite W beträgt 40 µm.

Fig. 7 zeigt eine grafische Darstellung für den Drain-Source-Strom in Abhängigkeit von der Drain-Source-Spannung für den vertikalen organischen Feldeffekttransistor nach Fig. 4 für verschiedene Gate-Source-Spannungen: Kurve 70 - 40V; Kurve 71 - 20V; Kurve 72 - 0V; Kurve 73 - -20V; Kurve 74 - -40V.

In Verbindung mit der Antihaft-Wirkung der haftselektiven Schicht 22 gegenüber dem organischen Halbleitermaterial wurde der Kontaktwinkel zwischen der auf der haftselektiven Schicht 22 abgeschiedenen organischen Halbleiterschicht sowie der haftselektiven Schicht 22 für verschiedene Beispiele untersucht. Tabelle 1 zeigt das Ergebnis für die untersuchten Beispiele.

**Tabelle 1**

| Substratbehandlung | Kontaktwinkel | Schichtausbildung |
|---|---|---|
| UVOCS behandeltes Glas | 11° | geschlossene, glatte Schicht |
| ODPA auf ITO | 19° | geschlossene, glatte Schicht |
| MPTMS auf Glas | 5° | geschlossene, glatte Schicht |
| Cytop | 52° | keine Schicht nachweisbar |
| nLOF | 23° | keine Schicht nachweisbar |
| PMMA | 12° | geschlossene, glatte Schicht |

Es ergibt sich, dass der Antihaftgrund bereitgestellt ist, wenn der Kontaktwinkel größer als 21 +/-1° ist.

Bei den in Tabelle 1 angegebenen Beispielen wurde jeweils auf ein beschichtetes oder unbeschichtetes Glassubstrat abgeschieden. Es handelt sich um eine Lösung auf 2 mg 6,13-Bis(triisopropylsilylethynyl)pentacene (Tips-Pentacene) in 1ml Tolul mit 300rpm (100rpm/s) (rpm - "Rotation per Minute") mit einem Spincoater. Anschließend wurde 5 Minuten bei 130°C auf einer Heizplatte geheizt. Außerdem wurde der Kontaktwinkel der gleichen Tips-Pentacene-Toluol-Lösung auf diesen Untergründen bestimmt.

Beim Behandeln des Glassubstrats in den verschiedenen Beispielen aus Tabelle 1 wurde wie folgt vorgegangen:
1) UVOCS Behandlung (10 min bei 22 mW/cm² UV-C Bestrahlung).
2) (Indium-Zinnoxid beschichtetes Glassubstrat) UVOCS Behandlung, dann 1 Stunde einlegen in eine Lösung aus 16 mg Octadecylphosphonsäure in 10 ml Isopropanol bei 50° C, dann gründlich abspülen mit Isopropanol und trocknen.
3) UVOCS Behandlung, dann 5 min einlegen in eine Lösung aus 0,2 ml Mercaptopropyltrimethoxysilan (MPTMS) in 10 ml Ethanol und 0,5 ml deionisiertem Wasser, dann trockenschleudern (Spincoater), dann 10 min bei 25° C liegenlassen, dann abspülen mit Isopropanol, dann bei 110° C auf einer Heizplatte ausheizen, dann auf 25° C abkühlen lassen.
4) Eine Lösung auf 2 ml Cytop CTL-809M in 7 ml CT-solv180 (beides von Asahi Glas Chemicals) 60 s mit 1500 rpm (500 rpm/s) mit eine Spincoater aufschleudern, dann 30 min bei 120° C auf einer Heizplatte ausheizen.
5) 5 ml AZ nLOF 2020 Photoresist bei 1500 rpm (500 rpm/s) aufschleudern, dann 2 min bei 120° C auf einer Heizplatte ausheizen, dann mit 170 mJ/cm² (-i-line, 436nm Wellenlänge) bestrahlen, dann 1 min bei 120° C auf einer Heizplatte ausheizen.
6) 3 ml PMMA:PGMEA (5wt%) bei 1500 rpm (500 rpm/s) aufschleudern, dann 2 min bei 80° C auf einer Heizplatte ausheizen, dann mit 90 mJ/cm² (i-line, 436nm Wellenlänge?) bestrahlen.

Als Substrate dient ein Borosilikat Glas. Das Substrate wird nach einem Ausbackschritt (120°C, 5min) mit 5 ml AZ nLOF 2020 Photoresist bei 1500 rpm (500 rpm/s) beschichtet und dann 2 min bei 120° C auf einer Heizplatte ausgeheizt. Anschließend wird die Probe mit 170 mJ/cm² (-i-line, 436nm) bestrahlt, dann 1 min bei 120° C auf einer Heizplatte ausgeheizt.

Weiterhin wurde der Einfluss des Lösemittels für die Haftung des Materials der organischen Halbleiterschicht 28 untersucht. Hierzu wurden verschiedene Lösemittel für eine Halbleiter-Lösung untersucht, welche beispielhaft zum Ausbilden der organischen Halbleiterschicht 28 nutzbar sind.

Als Halbleiter-Lösung wird eine Lösung von 2 mg 6,13-Bis(triisopropylsilylethynyl)pentacene (Tips-Pentacene) in 1ml Lösemittel genutzt. Hierbei werden Lösemittel mit verschiedenen Dipolmomenten (wie in Tabelle 2 aufgeführt) genutzt. Die Halbleiter-Lösung wird mit 300rpm (100rpm/s) (rpm - "Rotation per Minute") mit einem Spincoater auf das Substrat aufgeschleudert. Anschließend wurde 5 Minuten bei 130°C auf einer Heizplatte geheizt. Außerdem wurde der Kontaktwinkel der Halbleiter-Lösungen mit unterschiedlichen Lösemitteln zur vorher auf dem Substrat abgeschiedenen haftselektiven Schicht 22 untersucht.

**Tabelle 2**

| Lösemittel der Halbleiter-Lösung | Kontaktwinkel zwischen Substrate/Luft/ und Halbleiter-Lösung bei Raumtemperatur in Grad | Dipolmoment des Lösemittels in Debye | Schichtausbildung |
|---|---|---|---|
| Anisol | 27 | 1.38 | Keine Schicht nachweisbar |
| Benzonitril | 32 | 3.9 | Keine Schicht nachweisbar |
| Toluol | 21 | 0.375 | Keine Schicht nachweisbar |
| n-Decan | 6 | 0 | Glatte, geschlossene Schicht |
| n-Hexan | 5 | 0 | Geschlossene Schicht, inhomogene Dicke |

Für das mit NLOF 2020 behandelte Glas-Substrate wird ein zunehmender Kontaktwinkel bei zunehmendem Dipolmoment des Lösemittels beobachtet. Das bedeutet, dass durch eine Mischung von Lösemitteln verschiedener Dipolmomente der Kontaktwinkel auf der haftselektiven Schicht 22 gezielt eingestellt werden kann, was wiederum zu einer Haftung bzw. Nicht-Haftung der Halbleiter-Lösung führt. Für Kontaktwinkel von mehr als 21 ± 2 Grad kann keine Haftung des gelösten Halbleitermaterials auf dem Substrat erreicht werden. Im Falle einer unpolaren Oberfläche des NLOFs kann also ein Lösemittel für die Halbleiter-Lösung mit einer Dipolmoment von > 0.375D vorgesehen sein, um die Haftung auf dem NLOF zu unterbinden.

Die Kontaktwinkelmessungen wurden mit einem Kontaktwinkelmessgerät (Easydrop von der Firma Krüss, Auswertesoftware DSA 1.0) durchgeführt. Das Tropfenvolumen wurde zwischen 2 bis 4µl der jeweiligen Halbleiterlösung variiert und der Kontaktwinkel wurde für fünf verschiedene Tropfen auf mehr als zwei Positionen auf dem entsprechenden Substrat gemessen. Die Messwerte wurden jeweils aus den Einzelmessungen für eine spezielle Halbleiterlösung gemittelt (arithmetischer Mittelwert). Die Messungen wurden in Luft bei 22°C, 1010hPa und 35% relativer Luftfeuchtigkeit durchgeführt.

In der obigen Beschreibung werden die folgenden Abkürzungen verwendet: PGMEA: 1-Methoxy-2-propylacetat; PMMA: Polymethylmethacrylat; Cytop CTL-809M: Kommerzielles Produkt von Asahi Glass Corp.; CT-solv180: Kommerzielles Produkt von Asahi Glass Corp.; NLOF 2020: Kommerzielles Produkt von AZ electronic materials; ODPA: Octadecylphosphonsäure; MPTMS: Mercaptop-ropyltrimethoxysilan; Tips-Pentacene. 6,13-Bis(triisopropylsilylethynyl)pentacene; L: Kanallänge; OSC: Organischer Halbleiter; Vd: Drain-Source Spannung; VGS: Gate-Source-Spannung.

Die in der Beschreibung, den Ansprüchen und der Zeichnung offenbarten Merkmale können sowohl einzeln als auch in beliebiger Kombination miteinander für die Verwirklichung von Ausführungsformen relevant sein.

## Patentansprüche

1. Verfahren zum Herstellen eines vertikalen organischen Feldeffekttransistors, bei dem auf einem Substrat ein vertikaler organischer Feldeffekttransistor mit einer Schichtanordnung hergestellt wird, die Transistorelektroden, nämlich eine erste Elektrode (23; 24), eine zweite Elektrode (23; 24) und eine dritte Elektrode (32), elektrisch isolierende Schichten (25; 33) sowie eine organische Halbleiterschicht (28) aufweist, wobei das Verfahren die folgenden Schritte aufweist:
- Bereitstellen des Substrats (21);
- Abscheiden einer haftselektiven Schicht (22) auf dem Substrat (21);
- Herstellen einer Schichtteilstruktur (20) des vertikalen organischen Feldeffekttransistors, welche zumindest eine der Transistorelektroden (23; 24) und zumindest eine der elektrisch isolierenden Schichten (25) aufweist, die in einem jeweiligen Berührungskontaktbereich (26; 27) auf der haftselektiven Schicht (22) haften; und
- Herstellen der organischen Halbleiterschicht (28), indem wenigstens ein organisches Halbleitermaterial auf der Schichtteilstruktur (20) haftend abgeschieden wird und außerhalb der Schichtteilstruktur (20) die haftselektive Schicht (22) ein haftendes Abscheiden des wenigstens einen organischen Halbleitermaterials verhindert; und
- Herstellen einer verbleibenden Schichtteilstruktur (31) des vertikalen organischen Feldeffekttransistors.

2. Verfahren nach Anspruch 1, **dadurch gekennzeichnet, dass** die Schichtteilstruktur (20) mit der ersten Elektrode (23; 24) hergestellt wird.

3. Verfahren nach Anspruch 2, **dadurch gekennzeichnet, dass** die organische Halbleiterschicht (28) auf der ersten Elektrode (23; 24), der zweiten Elektrode (24; 23) und der zumindest einen elektrisch isolierenden Schicht (25) haftend abgeschieden wird.

4. Verfahren nach mindestens einem der vorangehenden Ansprüche, **dadurch gekennzeichnet, dass** beim Herstellen der Schichtteilstruktur (20) die zumindest eine der Transistorelektroden (23: 24) und die zumindest eine elektrisch isolierenden Schicht (25) strukturiert werden.

5. Verfahren nach Anspruch 4, **dadurch gekennzeichnet, dass** beim Strukturieren ein plasmaunterstütztes Ätzen ausgeführt wird und hierbei eine Plasmaanwendung auch eine Oberfläche der haftselektiven Schicht (22) außerhalb Schichtteilstruktur (20) erfasst.

6. Verfahren nach mindestens einem der vorangehenden Ansprüche, **dadurch gekennzeichnet, dass** eine Schicht aus dem wenigstens einen organischen Halbleitermaterial, die beim Herstellen der Halbleiterschicht außerhalb der Schichtteilstruktur nicht haftend abgeschieden wird, mit einer Oberfläche der haftselektiven Schicht (22) einen Kontaktwinkel von größer als 21 ± 2 Grad aufweist.

7. Verfahren nach Anspruch 6, **dadurch gekennzeichnet, dass** die Schicht aus dem wenigstens einen organischen Halbleitermaterial als nicht geschlossene Schicht gebildet wird.

8. Verfahren nach mindestens einem der vorangehenden Ansprüche, **dadurch gekennzeichnet, dass** die haftselektive Schicht (22) aus einem elektrisch isolierenden Material hergestellt wird.

9. Vertikaler organischer Feldeffekttransistor, der auf einem Substrat (21) eine Schichtanordnung mit Transistorelektroden, nämlich eine erste Elektrode (23; 24), eine zweite Elektrode (24; 23) und eine dritte Elektrode (32), elektrisch isolierenden Schichten (25; 33) sowie eine organische Halbleiterschicht (28) aus wenigstens einem organischen Halbleitermaterial aufweist, wobei die Schichtanordnung auf dem Substrat (21) auf einer haftselektiven Schicht (22) angeordnet ist, die für die Transistorelektroden sowie zumindest eine der elektrisch isolierenden Schichten (25; 34) einen Haftgrund und für die organische Halbleiterschicht (28) einen Antihaftgrund bereitstellt.

## Claims

1. A method for manufacturing a vertical organic field effect transistor, in which a vertical organic field effect transistor with a layer arrangement is manufactured on a substrate, which comprises transistor electrodes, namely a first electrode (23; 24), a second electrode (23; 24) and a third electrode (32), electrically insulating layers (25; 33) as well as an organic semiconductor layer (28), wherein the method comprises the following steps:
- providing the substrate (21);
- depositing an adhesion-selective layer (22) on the substrate (21);
- manufacturing a layer substructure (20) of the vertical organic field effect transistor, which comprises at least one of the transistor electrodes (23; 24) and at least one of the electrically insulating layers (25), which adhere to the adhesion-selective layer (22) in a respective touch contact region (26; 27); and
- manufacturing the organic semiconductor layer (28) by at least one organic semiconductor material being adhesively deposited on the layer substructure (20) and wherein outside the layer substructure (20) the adhesion-selective layer (22) prevents an adhesive deposition of the at least one organic semiconductor material; and
- manufacturing a remaining layer substructure (31) of the vertical organic field effect transistor.

2. The method according to claim 1, **characterized in that** the layer substructure (20) is manufactured with the first electrode (23; 24).

3. The method according to claim 2, **characterized in that** the organic semiconductor layer (28) is adhesively deposited on the first electrode (23; 24), the second electrode (24; 23) and the at least one electrically insulating layer (25).

4. The method according to at least one of the preceding claims, **characterized in that** when manufacturing the layer substructure (20), the at least one transistor electrodes (23; 24) and the at least one electrically insulating layer (25) are structured.

5. The method according to claim 4, **characterized in that** during structuring, a plasma-assisted etching is performed and wherein a plasma application also includes a surface of the adhesion-selective layer (22) outside the layer substructure (20).

6. The method according to at least one of the preceding claims, **characterized in that** a layer of the at least one organic semiconductor material which is not adhesively deposited when manufacturing the semiconductor layer outside the layer substructure has a contact angle of greater than 21 ± 2 degrees with a surface of the adhesion-selective layer (22).

7. Method according to claim 6, **characterized in that** the layer of the at least one organic semiconductor material is formed as a non-closed layer.

8. Method according to at least one of the preceding claims, **characterized in that** the adhesion-selective layer (22) is manufactured from an electrically insulating material.

9. Vertical organic field effect transistor, which comprises a layer arrangement with transistor electrodes, namely a first electrode (23; 24), a second electrode (24; 23) and a third electrode (32), electrically insulating layers (25; 33) as well as an organic semiconductor layer (28) of at least one organic semiconductor material, wherein the layer arrangement is arranged on the substrate (21) on an adhesion-selective layer (22), which provides an adhesion base for the transistor electrodes as well as at least one of the electrically insulating layers (25; 34) and an anti-adhesion base for the organic semiconductor layer (28).

## Revendications

1. Procédé pour la fabrication d'un transistor à effet de champ organique vertical où l'on fabrique, sur un substrat, un transistor à effet de champ organique vertical avec un agencement de couches qui présente des électrodes de transistor, à savoir une première électrode (23 ; 24), une deuxième électrode (23 ; 24) et une troisième électrode (32), des couches d'isolation électrique (25 ; 33) ainsi qu'une couche semi-conductrice organique (28), dans lequel le procédé présente les étapes suivantes :
la fourniture du substrat (21) ;
le dépôt d'une couche sélectivement adhésive (22) sur le substrat (21) ;
la fabrication d'une structure partielle de couche (20) du transistor à effet de champ organique vertical, laquelle présente au moins l'une des électrodes de transistor (23 ; 24) et au moins l'une des couches d'isolation électrique (25) lesquelles adhèrent, dans une zone de contact respective (26 ; 27), sur la couche sélectivement adhésive (22) ; et
la fabrication de la couche semi-conductrice organique (28) en ce qu'au moins un matériau semi-conducteur organique est déposé de manière à adhérer sur la structure partielle de couche (20) et en ce qu'à l'extérieur de la structure partielle de couche (20), la couche sélectivement adhésive (22) empêche un dépôt de manière à adhérer de l'au moins un matériau semi-conducteur organique ; et
la fabrication d'une structure partielle de couche résiduelle (31) du transistor à effet de champ organique vertical.

2. Procédé selon la revendication 1, **caractérisé en ce que** la structure partielle de couche (20) est fabriquée avec la première électrode (23 ; 24).

3. Procédé selon la revendication 2, **caractérisé en ce que** la couche semi-conductrice organique (28) est déposée de manière à adhérer sur la première électrode (23 ; 24), la deuxième électrode (24 ; 23), et l'au moins une couche d'isolation électrique (25).

4. Procédé selon l'une au moins des revendications précédentes, **caractérisé en ce que**, lors de la fabrication de la structure partielle de couche (20), l'au moins une des électrodes de transistor (23 ; 24) et l'au moins une couche d'isolation électrique (25) sont structurées.

5. Procédé selon la revendication 4, **caractérisé en ce que**, lors de la structuration, on réalise une gravure assistée par plasma et qu'à cet égard, une utilisation de plasma englobe également une surface de la couche sélectivement adhésive (22) à l'extérieur de la structure partielle de couche (20).

6. Procédé selon l'une au moins des revendications précédentes, **caractérisé en ce qu'**une couche en l'au moins un matériau semi-conducteur organique laquelle, lors de la fabrication de la couche semi-conductrice, est déposée de manière à ne pas adhérer à l'extérieur de la structure partielle de couche, présente un angle de contact avec une surface de la couche sélectivement adhésive (22) qui est supérieur à 21 ± 2 degrés.

7. Procédé selon la revendication 6, **caractérisé en ce que** la couche en l'au moins un matériau semi-conducteur organique est réalisée en tant que couche non fermée.

8. Procédé selon l'une au moins des revendications précédentes, **caractérisé en ce que** la couche sélectivement adhésive (22) est fabriquée en un matériau d'isolation électrique.

9. Transistor à effet de champ organique vertical qui présente, sur un substrat (21), un agencement de couches avec des électrodes de transistor, à savoir une première électrode (23 ; 24), une deuxième électrode (24 ; 23) et une troisième électrode (32), des couches d'isolation électrique (25 ; 33) ainsi qu'une couche semi-conductrice organique (28) en au moins un matériau semi-conducteur organique, dans lequel l'agencement de couches sur le substrat (21) est disposé sur une couche sélectivement adhésive (22) qui fournit une base adhésive pour les électrodes de transistor ainsi que l'au moins une des couches d'isolation électrique (25 ; 34), et une base antiadhésive pour la couche semi-conductrice organique (28).
